# EUROPÄISCHE PATENTANMELDUNG

(11) **EP 1 280 276 A2**
(43) Veröffentlichungstag der Anmeldung: **29.01.2003**
(21) Anmeldenummer: 02016493.5
(22) Anmeldetag: 23.07.2002
(51) Int. Cl.: H03K 19/00

(54) **Anordnung und Verfahren zum Umschalten von Transistoren**

(30) Priorität: 26.07.2001 DE 10136320
(71) Anmelder: Infineon Technologies AG, 81669 München (DE)
(72) Erfinder: Bernardon, Derek, 9500 Villach (DE)
(74) Vertreter: Repkow, Ines, Dr. Dipl.-Ing.

(57) **Zusammenfassung**

Es werden eine Anordnung und ein Verfahren zum gleichzeitigen Umschalten eines sich im leitenden Zustand befindenden Transistors in den nicht leitenden Zustand und eines dazu in Reihe geschalteten, sich im nicht leitenden Zustand befindenden Transistors in den leitenden Zustand beschrieben. Die beschriebene Anordnung und das beschriebene Verfahren zeichnen sich dadurch aus, daß dafür gesorgt wird, daß sich beim Umschalten der Transistoren vom leitenden in den nicht leitenden Zustand bzw. vom nicht leitenden in den leitenden Zustand das Gatepotential des Transistors, der durch das Umschalten vom nicht leitenden Zustand in den leitenden Zustand gebracht wird, langsamer ändert als das Gatepotential des Transistors, der durch das Umschalten vom leitenden Zustand in den nicht leitenden Zustand gebracht wird.

## Beschreibung

Die vorliegende Erfindung betrifft eine Anordnung gemäß dem Oberbegriff des Patentanspruchs 1, und ein Verfahren gemäß dem Oberbegriff des Patentanspruchs 17, d.h. eine Anordnung und ein Verfahren zum gleichzeitigen Umschalten eines sich im leitenden Zustand befindenden Transistors in den nicht leitenden Zustand und eines dazu in Reihe geschalteten, sich im nicht leitenden Zustand befindenden Transistors in den leitenden Zustand.

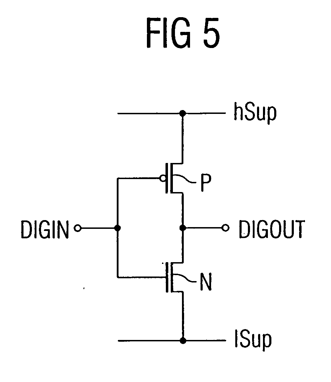

Eine Schaltung, die zwei so zu betreibende Transistoren enthält, ist in Figur 5 dargestellt.

Die gezeigte Schaltung besteht aus einem PMOS-Transistor P und einem dazu in Reihe geschalteten NMOS-Transistor N, wobei
- der Transistor P mit dem ersten Pol hSup einer Versorgungsspannung verbunden ist,
- der Transistor N mit dem zweiten Pol lSup der Versorgungsspannung verbunden ist,
- die Gateanschlüsse der Transistoren P und N mit einem digitalen Eingangssignal DIGIN der Anordnung verbunden sind, und
- zwischen den Transistoren P und N ein digitales Ausgangssignal DIGOUT der Anordnung abgegriffen wird.

Von den Transistoren P und N befindet sich unabhängig vom Pegel des Eingangssignals DIGIN jeweils einer der Transistoren im leitenden Zustand, und der jeweils andere Transistor im nicht leitenden Zustand.

Bei einem Wechsel des Pegels des Eingangssignals DIGIN wird der sich im leitenden Zustand befindende Transistor in den nicht leitenden Zustand versetzt, und der sich im nicht leitenden Zustand befindende Transistor in den leitenden Zustand versetzt.

Eine solche Anordnung kommt beispielsweise in einem Inverter zum Einsatz.

Ein bekanntes Problem solcher Anordnungen besteht darin, daß es während des gleichzeitigen Umschaltens der Transistoren eine Phase gibt, in welcher sich beide Transistoren im leitenden Zustand befinden. In dieser Phase werden der erste Pol hSup und der zweite Pol lSup der Versorgungsspannung über die Transistoren P und N kurzgeschlossen.

Dies ist aus verschiedenen Gründen nachteilig. Insbesondere fließt in den Kurzschluß-Phasen ein sehr großer Strom,
- der zu einer starken Erwärmung der Anordnung führt und die Transistoren P und N sogar zerstören kann, und
- der zur Folge haben kann, daß an in Reihe zu den Transistoren P und N vorhandenen parasitären Induktivitäten aufgrund des großen di/dt beträchtliche Spannungen abfallen, was insbesondere bei schnell aufeinanderfolgenden Umschaltvorgängen eine erhebliche Störung des Ausgangssignals DIGOUT zur Folge hat.

Es existiert bekanntlich bereits eine Vielzahl von Vorschlägen zur Beseitigung der genannten Probleme. Die bekannten Vorschläge sind jedoch nur mit großem Aufwand realisierbar und/oder können die genannten Probleme nicht zufriedenstellend beseitigen.

Der vorliegenden Erfindung liegt daher die Aufgabe zugrunde, die Vorrichtung gemäß dem Oberbegriff des Patentanspruchs 1 und das Verfahren gemäß dem Oberbegriff des Patentanspruchs 17 derart weiterzubilden, daß auf einfache Weise zuverlässig und ohne Inkaufnahme anderer Nachteile verhinderbar ist, daß beim Umschalten der Transistoren Kurzschlüsse auftreten.

Diese Aufgabe wird erfindungsgemäß durch die in Patentanspruch 1 beanspruchte Anordnung und durch das in Patentanspruch 17 beanspruchte Verfahren gelöst.

Die erfindungsgemäße Anordnung zeichnet sich dadurch aus, daß sie dafür sorgt, daß sich beim Umschalten der Transistoren vom leitenden in den nicht leitenden Zustand bzw. vom nicht leitenden in den leitenden Zustand das Gatepotential des Transistors, der durch das Umschalten vom nicht leitenden Zustand in den leitenden Zustand gebracht wird, langsamer ändert als das Gatepotential des Transistors, der durch das Umschalten vom leitenden Zustand in den nicht leitenden Zustand gebracht wird.

Das erfindungsgemäße Verfahren zeichnet sich dadurch aus, daß dafür gesorgt wird, daß sich beim Umschalten der Transistoren vom leitenden in den nicht leitenden Zustand bzw. vom nicht leitenden in den leitenden Zustand das Gatepotential des Transistors, der durch das Umschalten vom nicht leitenden Zustand in den leitenden Zustand gebracht wird, langsamer ändert als das Gatepotential des Transistors, der durch das Umschalten vom leitenden Zustand in den nicht leitenden Zustand gebracht wird.

Dadurch kann der ursprünglich nicht leitende Transistor selbst im Fall, daß das Umschalten der Transistoren gleichzeitig gestartet wird, erst dann in den leitenden Zustand gelangen, wenn der ursprünglich leitende Transistor sich nicht mehr im voll durchgeschalteten Zustand befindet. Die Folge hiervon ist, daß sich zu keinem Zeitpunkt beide Transistoren gleichzeitig in den voll leitenden Zustand befinden können; während des Umschaltens befindet sich mindestens einer der Transistoren in einem Zustand, in welchem er als eine den Stromfluß durch die Transistoren begrenzende Stromquelle wirkt.

Durch die beanspruchte Anordnung und das beanspruchte Verfahren kann mithin auf einfache Weise zuverlässig und ohne Inkaufnahme von anderen Nachteilen verhindert werden, daß beim Umschalten der Transistoren Kurzschlüsse auftreten.

Vorteilhafte Weiterbildungen der Erfindung sind den Unteransprüchen, der folgenden Beschreibung, und den Figuren entnehmbar.

Die Erfindung wird nachfolgend anhand von Ausführungsbeispielen unter Bezugnahme auf die Figuren näher erläutert. Es zeigen
- Figur 1: ein erstes Ausführungsbeispiel einer Anordnung zum gleichzeitigen Umschalten von zwei in Reihe geschalteten und sich in unterschiedlichen Schaltzuständen befindenden Transistoren,
- Figur 2: die zeitlichen Verläufe ausgewählter Ströme und Spannungen, die sich beim Umschalten der umzuschaltenden Transistoren durch die in der Figur 1 gezeigte Anordnung einstellen,
- Figur 3: die zeitlichen Verläufe ausgewählter Ströme und Spannungen, die sich bei einem erneuten Umschalten der umzuschaltenden Transistoren durch die in der Figur 1 gezeigte Anordnung einstellen,
- Figur 4: ein zweites Ausführungsbeispiel einer Anordnung zum gleichzeitigen Umschalten von zwei in Reihe geschalteten und sich in unterschiedlichen Schaltzuständen befindenden Transistoren, und
- Figur 5: eine herkömmliche Schaltung mit zwei in Reihe geschalteten Transistoren, die unterschiedliche Schaltzustände aufweisen und jeweils gleichzeitig umgeschaltet werden.

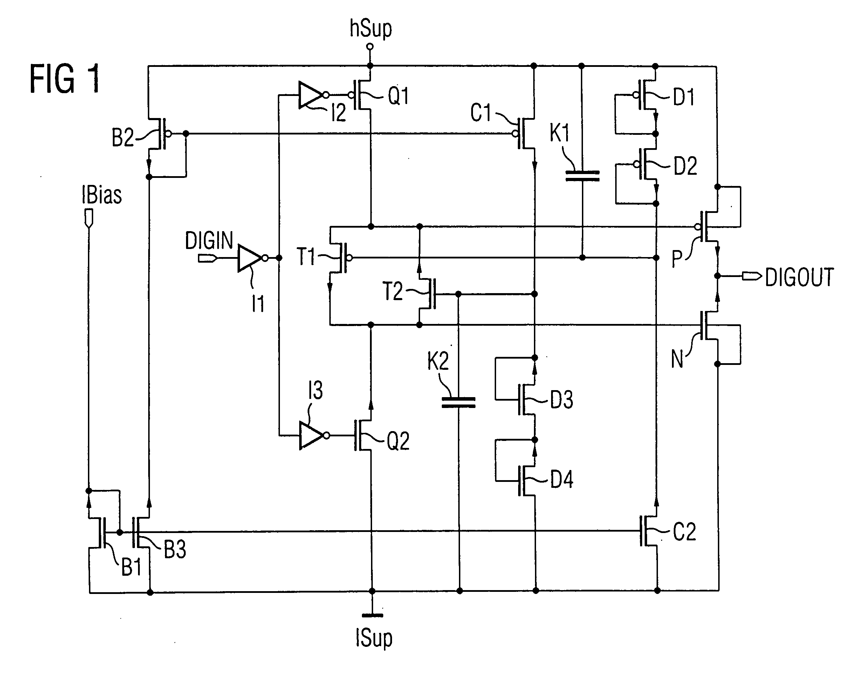

Die in der Figur 1 gezeigte Anordnung umfaßt PMOS-Transistoren P, B2, C1, D1, D2, Q1, und T1, NMOS-Transistoren N, B1, B3, C2, D3, D4, Q2, und T2, Kondensatoren K1 und K2, und Inverter I1 I2 und I3.

Die Transistoren, die im wesentlichen gleichzeitig umgeschaltet werden sollen, sind der PMOS-Transistor P und der NMOS-Transistor N. Diese Transistoren sind in Reihe geschaltet und zwischen dem positiven Pol hSup und dem negativen Pol lSup einer Versorgungsspannung angeordnet. Genauer gesagt sind der Transistor P mit dem positiven Pol hSup, und der Transistor N mit dem negativen Pol lSup der Versorgungsspannung verbunden. Der negative Pol lSup der Versorgungsspannung entspricht im betrachteten Beispiel dem Massepotential.

Es sei bereits an dieser Stelle darauf hingewiesen,
- daß die umzuschaltenden Transistoren P und N auch vertauscht (mit den jeweils anderen Polen der Versorgungsspannung verbunden) sein können,
- daß es bei den umzuschaltenden Transistoren auch um komplementär angesteuerte Transistoren vom selben Typ handeln kann, und/oder
- daß es sich bei den Transistoren auch um andere Transistoren als MOS-Transistoren (beispielsweise um Bipolar-Transistoren) handeln kann.

Das im wesentlichen gleichzeitige Umschalten der Transistoren P und N wird durch ein digitales Signal DIGIN veranlaßt, welches zugleich das Eingangssignal der Anordnung ist. Im Gegensatz zu der in der Figur 5 gezeigten Anordnung wird dieses Signal jedoch nicht direkt auf die Gateanschlüsse der Transistoren P und N gegeben.

Das Signal DIGIN wird über die Inverter I1 und I2 dem Gateanschluß des Transistors Q1, und über die Inverter I1 und I3 dem Gateanschluß des Transistors Q2 zugeführt, wobei der Transistor Q1 den Gateanschluß des Transistors P mit dem positiven Pol hSup der Versorgungsspannung, und der Transistor Q2 den Gateanschluß des Transistors N mit dem negativen Pol lSup der Versorgungsspannung verbindet.

Die Gate-Anschlüsse der Transistoren P und N sind darüber hinaus über den Transistor T1 und den parallel dazu angeordneten Transistor T2 miteinander verbunden.

Die Gatespannung des Transistors T1 wird an einem parallel zu den Transistoren P und N angeordneten und aus den Transistoren D1, D2 und C2 bestehenden Spannungsteiler abgegriffen. Die Transistoren D1, D2, und C2 sind in Reihe geschaltet, wobei der Transistor D1 mit dem positiven Pol hSup der Versorgungsspannung, und der Transistor C2 mit dem negativen Pol lSup der Versorgungsspannung verbunden ist, und wobei die Transistoren D1 und D2 als Dioden verwendet werden. Die Spannung, die dem Gateanschluß des Transistors T1 zugeführt wird, wird an einer zwischen den Transistoren D2 und C2 liegenden Stelle abgegriffen.

Die Transistoren T1, D1, D2 und C2 sind so dimensioniert, daß der während des Umschaltens der Transistoren P und N über diese fließende Strom, und zwar nur dieser Strom begrenzt wird. Dies wird später noch genauer erläutert.

Der Transistor C2 ist Bestandteil eines durch die Transistoren B1, B3 und C2 gebildeten Stromspiegels, wobei es von dem den Transistor B1 durchfließenden Strom abhängt, wie groß die durch die Transistoren B3 und C2 fließenden Ströme sind. In den Transistor B1 wird ein Strom IBias eingeprägt. Der Transistor C2 stellt mithin eine Stromquelle dar, die einen über IBias einstellbaren Strom abgibt; über die Größe dieses Stromes, also letztlich über den Biasstrom IBias können das Gatepotential des Transistors T1 und damit die Geschwindigkeit und der Verlauf des Ladens bzw. Entladens der Gateanschlüsse der Transistoren P und N variiert werden.

Zwischen dem Gateanschluß des Transistors T1 und dem positiven Pol hSup der Versorgungsspannung, also parallel zu den Transistoren D1 und D2, ist der Kondensator K1 angeordnet; dieser Kondensator dient zur Stabilisierung der Gatespannung des Transistors T1.

Die Gatespannung des vorstehend bereits erwähnten Transistors T2 wird an einem parallel zu den Transistoren P und N angeordneten und aus den Transistoren C1, D3, und D4 bestehenden Spannungsteiler abgegriffen. Die Transistoren C1, D3, und D4 sind in Reihe geschaltet, wobei der Transistor C1 mit dem positiven Pol hSup der Versorgungsspannung, und der Transistor D4 mit dem negativen Pol lSup der Versorgungsspannung verbunden ist, und wobei die Transistoren D3 und D4 als Dioden verwendet werden. Die Spannung, die dem Gateanschluß des Transistors T2 zugeführt wird, wird an einer zwischen den Transistoren C1 und D3 liegenden Stelle abgegriffen.

Die Transistoren T2, C1, D3, und D4 sind so dimensioniert, daß der während des Umschaltens der Transistoren P und N über diese fließende Strom, und zwar nur dieser Strom begrenzt wird. Dies wird später noch genauer erläutert.

Der Transistor C1 ist Bestandteil eines durch die Transistoren B2 und C1 gebildeten Stromspiegels, wobei es von dem den Transistor B2 fließenden Strom abhängt, wie groß die durch die Transistoren C1 fließende Strom ist. Der Transistor B2 ist in Reihe zum Transistor B3 geschaltet, wodurch durch den Transistor B3 ein von IBias abhängender Strom fließt. Der Transistor C1 stellt mithin eine Stromquelle dar, die einen über IBias einstellbaren Strom abgibt; über die Größe dieses Stromes, also letztlich über den Biasstrom IBias können das Gatepotential des Transistors T2 und damit die Geschwindigkeit und der Verlauf des Ladens bzw. Entladens der Gateanschlüsse der Transistoren P und N variiert werden.

Zwischen dem Gateanschluß des Transistors T2 und dem negativen Pol lSup der Versorgungsspannung, also parallel zu den Transistoren D3 und D4, ist der Kondensator K2 angeordnet; dieser Kondensator dient zur Stabilisierung der Gatespannung des Transistors T2.

Die in der Figur 1 gezeigte Anordnung arbeitet wie folgt:

Zunächst sei angenommen, daß sich die Anordnung im stationären Zustand befindet, und daß DIGIN gleich 0 ist. Dann befindet sich der Transistor Q1 im leitenden Zustand, und der Transistor Q2 im nicht leitenden Zustand. Dadurch werden sowohl der Gateanschluß des Transistors P als auch der Gateanschluß des Transistors N auf hohes Potential gezogen, was seinerseits wiederum zur Folge hat, daß sich an einem zwischen den Transistoren P und N liegenden digitalen Ausgangsanschluß DIGOUT der Anordnung eine Spannung von 0 V einstellt.

Wenn ausgehend hiervon das Eingangssignal DIGIN auf 1 umgeschaltet wird, gelangen der Transistor Q1 in den nicht leitenden Zustand, und der Transistor Q2 in den leitenden Zustand, wodurch das sich am Gateanschluß des Transistors P einstellende Potential und das sich am Gateanschluß des Transistors N einstellende Potential gleichzeitig zu fallen beginnen.

Das Entladen des Gateanschlusses des Transistors N erfolgt sehr schnell, weil der Gateanschluß über den leitenden Transistor Q2 mit Masse verbunden ist. Das Entladen des Gateanschlusses des Transistors P erfolgt langsamer, weil der Entladestrom zusätzlich über die als Widerstände wirkenden Transistoren T1 und T2 fließen muß.

Sobald die sich am Gateanschluß des Transistors P einstellende Spannung einen bestimmten, etwas unterhalb seiner Thresholdspannung liegenden Wert erreicht, sinkt die Spannung nicht weiter. Die Gatespannung des Transistors P, bei welcher dies der Fall ist, hängt von der am Transistor T1 abfallenden Spannung ab, welche ihrerseits von der Ansteuerung des Transistors T1 abhängt. In diesem Zustand wirkt der Transistor P als Stromquelle, durch welche der über die Transistoren P und N zwischen dem positiven Pol hSup und dem negativen Pol lSup der Versorgungsspannung fließende Strom begrenzt wird.

Die sich am Gateanschluß des Transistors N einstellende Spannung, welche zu dem Zeitpunkt, zu welchem der Transistor P als Stromquelle zu wirken beginnt, immer noch hoch ist, fällt weiter ab. Der Gateanschluß des Transistors N wird aber nicht vollständig entladen. Sobald die sich am Gateanschluß des Transistors N einstellende Spannung einen bestimmten, etwas oberhalb seiner Thresholdspannung liegenden Wert erreicht, sinkt die Gatespannung nicht weiter. Die Gatespannung, bei welcher dies der Fall ist, hängt von der am Transistor T2 abfallenden Spannung ab, welche ihrerseits von der Ansteuerung des Transistors T2 abhängt.

Nun wirkt der Transistor N als Stromquelle, welche den über die Transistoren P und N zwischen dem positiven Pol hSup und dem negativen Pol lSup der Versorgungsspannung fließenden Strom begrenzt, und wird der Gateanschluß des Transistors P über die als Widerstände wirkenden Transistoren T1 und T2 weiter entladen. Wenn die sich am Gateanschluß des Transistors P einstellende Spannung die sich am Gateanschluß des Transistors P einstellende Spannung erreicht, werden die Gateanschlüsse der Transistoren P und N auf 0 V entladen.

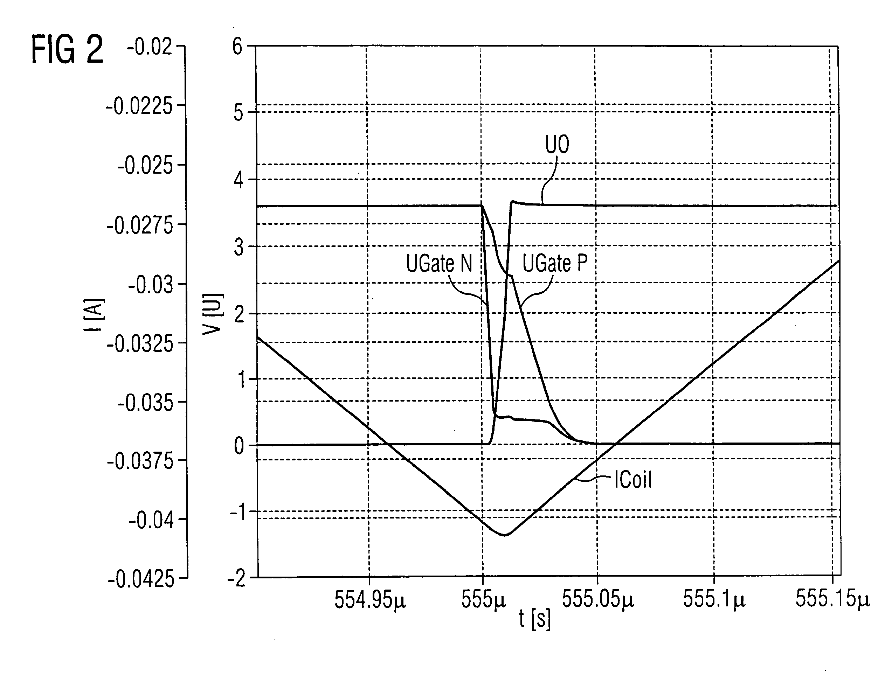

Die sich beim Umschalten des Eingangssignals DIGIN von 0 auf 1 ergebenden Verläufe
- der sich am Gateanschluß des Transistors N einstellenden Spannung UgateN,
- der sich am Gateanschluß des Transistors P einstellenden Spannung UgateP,
- der sich am Ausgangsanschluß DIGOUT der Anordnung einstellenden Spannung UO, und
- des Stromes ICoil, der an eine am Ausgangsanschluß DIGOUT der Anordnung angeschlossene Spule abgegeben wird,
sind in Figur 2 veranschaulicht.

Die beim Umschalten des Eingangssignals DIGIN von 1 auf 0 ablaufenden Vorgänge entsprechen den beim Umschalten des Eingangssignals DIGIN von 0 auf 1 ablaufenden Vorgängen.

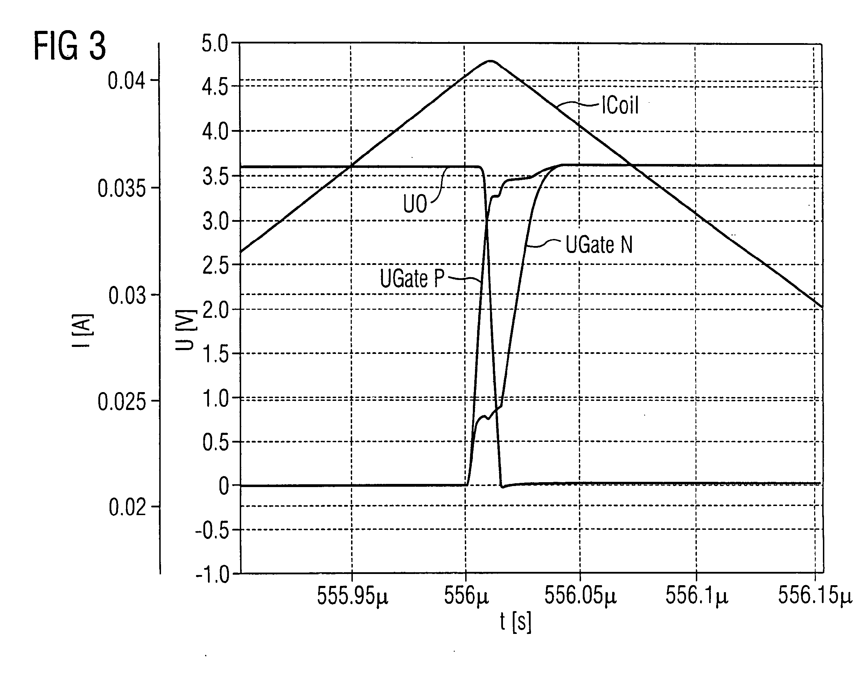

Die sich beim Umschalten des Eingangssignals DIGIN von 1 auf 0 ergebenden Verläufe
- der sich am Gateanschluß des Transistors N einstellenden Spannung UgateN,
- der sich am Gateanschluß des Transistors P einstellenden Spannung UgateP,
- der sich am Ausgangsanschluß DIGOUT der Anordnung einstellenden Spannung UO, und
- des Stromes ICoil, der an eine am Ausgangsanschluß DIGOUT der Anordnung angeschlossene Spule abgegeben wird,
   sind in Figur 3 veranschaulicht.

Der Vorteil der in der Figur 1 gezeigten Anordnung besteht darin, daß die Pole hSup und lSup der Versorgungsspannung zu keinem Zeitpunkt über die Transistoren P und N kurzgeschlossen sind. Dies gilt auch bei veränderten oder sich verändernden Bedingungen: die in den Figuren 2 und 3 gezeigten Stromund Spannungsverläufe adaptieren sich bei Veränderungen der Temperatur und/oder sonstigen Parametern von selbst. Darüber hinaus erfolgt die Ansteuerung der Transistoren P und N ohne Rückkopplung, so daß auch keine Stabilitätsprobleme entstehen können.

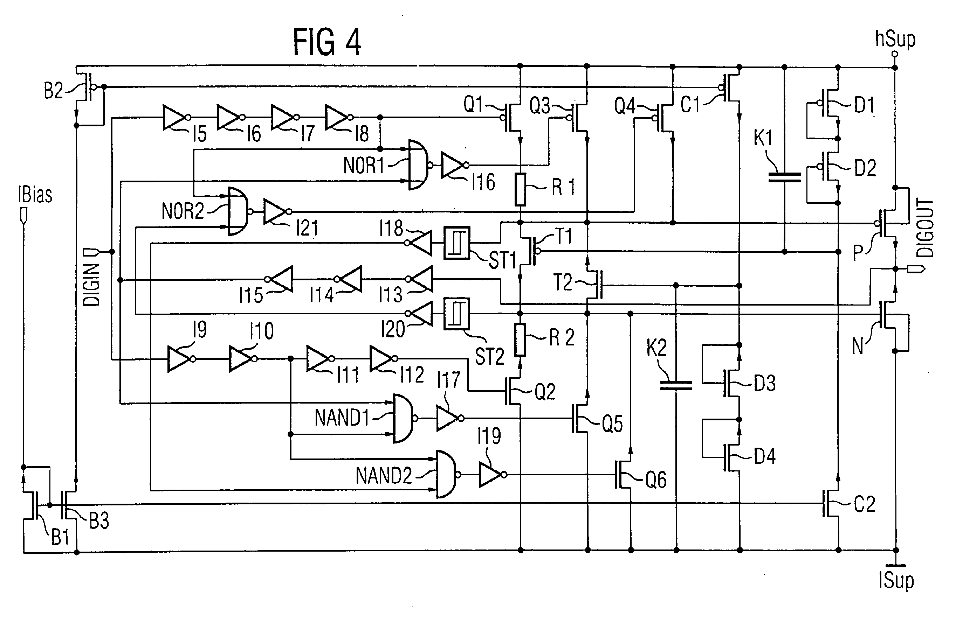

In der Figur 4 ist ein zweites Ausführungsbeispiel einer Anordnung zum gleichzeitigen Umschalten von zwei in Reihe geschalteten und sich in verschiedenen Schaltzuständen befindenden Transistoren gezeigt.

Die in der Figur 4 gezeigte Anordnung entspricht großteils der in der Figur 1 gezeigten Anordnung. Mit den gleichen Bezugszeichen bezeichnete Komponenten sind identische oder einander entsprechende Komponenten.

Die vorhandenen Unterschiede bestehen darin, daß
- das Eingangssignal DIGIN dem Transistor Q1 über in Reihe geschaltete Inverter 15, I6, I7, und I8, und dem Transistor Q2 über in Reihe geschaltete Inverter I9, I10, I11, und I12 zugeführt wird,
- in Reihe zum Transistor Q1 ein Widerstand R1 geschaltet ist, und in Reihe zum Transistor Q2 ein Widerstand R2 geschaltet ist,
- parallel zur Reihenschaltung von Transistor Q1 und Widerstand R1 ein PMOS-Transistor Q3 angeordnet ist,
- parallel zur Reihenschaltung von Transistor Q1 und Widerstand R1 ein PMOS-Transistor Q4 angeordnet ist,
- parallel zur Reihenschaltung von Transistor Q2 und Widerstand R2 ein NMOS-Transistor Q5 angeordnet ist,
- parallel zur Reihenschaltung von Transistor Q2 und Widerstand R2 ein NMOS-Transistor Q6 angeordnet ist,
wobei
- die Transistoren Q3 und Q5 abhängig vom Eingangssignal DIGIN und der sich am Ausgangsanschluß DIGOUT einstellenden Spannung angesteuert werden,
- der Transistor Q4 abhängig vom Eingangssignal DIGIN und der sich am Gateanschluß des Transistors N einstellenden Spannung angesteuert wird, und
- der Transistor Q6 abhängig vom Eingangssignal DIGIN und der sich am Gateanschluß des Transistors P einstellenden Spannung angesteuert wird.

Die Ansteuerung der Transistoren Q3 und Q5 in Abhängigkeit vom Eingangssignal DIGIN und der sich am Ausgangsanschluß DIGOUT einstellenden Spannung erfolgt im einzelnen wie folgt:

Die sich am Ausgangsanschluß DIGOUT einstellende Spannung wird durch die in Reihe geschalteten Inverter I13, I14 und I15 invertiert und einem ersten Eingangsanschluß des NOR-Gatters NOR1 sowie einem ersten Eingangsanschluß des NAND-Gatters NAND1 zugeführt.

Dem zweiten Eingangsanschluß des NOR-Gatters NOR1 wird das durch die Inverter I5 bis I8 vierfach invertierte und entsprechend zeitlich verzögerte Eingangssignal DIGIN zugeführt. Das NOR-Gatter NOR1 unterzieht die ihm zugeführten Signale einer NOR-Operation und gibt das Ergebnis an den Inverter I16 aus. Dieser invertiert das ihm zugeführte Signal und gibt das Ergebnis an den Gateanschluß des Transistors Q3 aus.

Dem zweiten Eingangsanschluß des NAND-Gatters NAND1 wird das durch die Inverter I9 und I10 zweifach invertierte und entsprechend zeitlich verzögerte Eingangssignal DIGIN zugeführt. Das NAND-Gatter NAND1 unterzieht die ihm zugeführten Signale einer NAND-Operation und gibt das Ergebnis an den Inverter I17 aus. Dieser invertiert das ihm zugeführte Signal und gibt das Ergebnis an den Gateanschluß des Transistors Q5 aus.

Die Ansteuerung des Transistors Q4 in Abhängigkeit vom Eingangssignal DIGIN und der sich am Gateanschluß des Transistors N einstellenden Spannung erfolgt im einzelnen wie folgt:

Die sich am Gateanschluß des Transistors N einstellende Spannung wird dem Schmitt-Trigger ST2 zugeführt, und dessen Ausgangssignal wird über den Inverter I20 an den ersten Eingangsanschluß des NOR-Gatters NOR2 weitergeleitet.

Dem zweiten Eingangsanschluß des NOR-Gatters NOR2 wird das durch die Inverter I5 bis I8 vierfach invertierte und entsprechend zeitlich verzögerte Eingangssignal DIGIN zugeführt. Das NOR-Gatter NOR2 unterzieht die ihm zugeführten Signale einer NOR-Operation und gibt das Ergebnis an den Inverter I21 aus. Dieser invertiert das ihm zugeführte Signal und gibt das Ergebnis an die Gateanschluß des Transistors Q4 aus.

Die Ansteuerung des Transistors Q6 in Abhängigkeit vom Eingangssignal DIGIN und der sich am Gateanschluß des Transistors P einstellenden Spannung erfolgt im einzelnen wie folgt:

Die sich am Gateanschluß des Transistors P einstellende Spannung wird dem Schmitt-Trigger ST1 zugeführt, und dessen Ausgangssignal wird über den Inverter I18 an den ersten Eingangsanschluß des NAND-Gatters NAND2 weitergeleitet.

Dem zweiten Eingangsanschluß des NAND-Gatters NAND2 wird das durch die Inverter I9 und I10 zweifach invertierte und entsprechend zeitlich verzögerte Eingangssignal DIGIN zugeführt. Das NAND-Gatter NAND2 unterzieht die ihm zugeführten Signale einer NAND-Operation und gibt das Ergebnis an den Inverter I19 aus. Dieser invertiert das ihm zugeführte Signal und gibt das Ergebnis an den Gateanschluß des Transistors Q6 aus.

Wie aus den vorstehenden Erläuterungen ersichtlich ist, werden die in der in der Figur 4 gezeigten Anordnung zusätzlich vorgesehenen Transistoren Q3 bis Q6 in Abhängigkeit von den sich in der Anordnung einstellenden Verhältnissen angesteuert. Unter welchen Bedingungen diese Transistoren in den leitenden bzw. in den nicht leitenden Zustand versetzt werden, ist dem vorstehend beschriebenen Aufbau des die betreffenden Transistoren ansteuernden Teils der Anordnung entnehmbar und bedarf keiner weiteren Erläuterung.

Durch das Versetzen der Transistoren Q3 bis Q6 in den leitenden bzw. den nicht leitenden Zustand kann Einfluß darauf genommen werden, wie schnell die Gateanschlüsse der Transistoren P und N in den einzelnen Phasen des Umschaltvorganges geladen oder entladen werden. Durch das Versetzen einzelner oder mehrerer der Transistoren Q3 bis Q6 in den leitenden Zustand kann das Laden und Entladen der Gateanschlüsse der Transistoren P und N beschleunigt werden. Dadurch können die Vorgänge, die durchzuführen sind, um die Transistoren P und N im wesentlichen gleichzeitig ohne Kurzschluß umzuschalten, optimal an die jeweils herrschenden Verhältnisse angepaßt werden.

Es dürfte einleuchten und bedarf keiner näheren Erläuterung, daß die in der Figur 4 gezeigte Anordnung nur als ein Beispiel zur praktischen Realisierung einer Anordnung anzusehen ist, durch welche die Geschwindigkeit des Ladens und Entladens der Gateanschlüsse der Transistoren P und N während des Umschaltvorganges variierbar ist. Es können
- sowohl die Bedingungen, unter welchen die zusätzlichen Transistoren Q3 bis Q6 in den leitenden und in den nicht leitenden Zustand versetzt werden,
- als auch der Aufbau der die zusätzlichen Transistoren Q3 bis Q6 steuernden Schaltungsteile,
- als auch die Art und Weise, auf welche eine Variierung der Geschwindigkeit des Ladens und Entladens der Gateanschlüsse der Transistoren P und N durchgeführt wird,
modifiziert werden.

Durch die beschriebene Anordnung und das beschriebene Verfahren kann unabhängig von den Einzelheiten der praktischen Realisierung auf einfache Art und Weise zuverlässig verhindert werden, daß beim Umschalten der Transistoren P und N Kurzschlüsse auftreten.

### Bezugszeichenliste

- Bx: Transistoren
- Cx: Transistoren
- DIGIN: digitales Eingangssignal
- DIGOUT: digitales Ausgangssignal
- Dx: Transistoren
- hSup: positiver Pol der Versorgungsspannung
- Ix: Inverter
- Kx: Kondensatoren
- lSup: negativer Pol der Versorgungsspannung
- N: umzuschaltender NMOS-Transistor
- NANDx: NAND-Gatter
- NORx: NOR-Gatter
- P: umzuschaltender PMOS-Transistor
- Qx: Transistoren
- ST: Schmitt-Trigger
- Tx: Transistoren

## Patentansprüche

1. Anordnung zum gleichzeitigen Umschalten eines sich im leitenden Zustand befindenden Transistors in den nicht leitenden Zustand und eines dazu in Reihe geschalteten, sich im nicht leitenden Zustand befindenden Transistors in den leitenden Zustand,
**dadurch gekennzeichnet,**
**daß** die Anordnung dafür sorgt, daß sich beim Umschalten der Transistoren (P, N) vom leitenden in den nicht leitenden Zustand bzw. vom nicht leitenden in den leitenden Zustand das Gatepotential des Transistors, der durch das Umschalten vom nicht leitenden Zustand in den leitenden Zustand gebracht wird, langsamer ändert als das Gatepotential des Transistors, der durch das Umschalten vom leitenden Zustand in den nicht leitenden Zustand gebracht wird.

2. Anordnung nach Anspruch 1,
**dadurch gekennzeichnet,**
**daß** die Anordnung dafür sorgt, daß sich beim Umschalten der Transistoren (P, N) vom leitenden in den nicht leitenden Zustand bzw. vom nicht leitenden in den leitenden Zustand die Gatepotentiale der Transistoren gleichzeitig zu ändern beginnen.

3. Anordnung nach Anspruch 1 oder 2,
**dadurch gekennzeichnet,**
**daß** die Anordnung die Transistoren (P, N) während des Umschaltens vom leitenden in den nicht leitenden Zustand bzw. vom nicht leitenden in den leitenden Zustand so ansteuert, daß in Phasen, in welchen sich keiner der Transistoren im nicht leitenden Zustand befindet, wenigstens einer der Transistoren in einen Zustand versetzt wird, in welchem er als eine den Stromfluß durch die Transistoren begrenzende Stromquelle wirkt.

4. Anordnung nach einem der vorhergehenden Ansprüche,
**dadurch gekennzeichnet,**
**daß** einer der Transistoren (P, N) ein PMOS-Transistor ist, und der andere Transistor ein NMOS-Transistor ist.

5. Anordnung nach einem der vorhergehenden Ansprüche,
**dadurch gekennzeichnet,**
**daß** der Sourceanschluß des einen Transistors (P) mit einem ersten Pol (hSup) einer Versorgungsspannung verbunden ist, und daß der Sourceanschluß des anderen Transistors (N) mit einem zweiten Pol (lSup) der Versorgungsspannung verbunden ist.

6. Anordnung nach einem der vorhergehenden Ansprüche,
**dadurch gekennzeichnet,**
**daß** es von einem der Anordnung zugeführten Eingangssignal (DIGIN) abhängt, welcher der Transistoren (P, N) sich im leitenden Zustand befindet und welcher der Transistoren sich im nicht leitenden Zustand befindet, wobei die Transistoren jedoch nicht durch dieses Eingangssignal angesteuert werden.

7. Anordnung nach einem der vorhergehenden Ansprüche,
**dadurch gekennzeichnet,**
**daß** der Gateanschluß des ersten Transistors (P) über einen ersten zusätzlichen Transistor (Q1) mit dem ersten Pol der (hSup) Versorgungsspannung verbunden ist, und daß der Gateanschluß des zweiten Transistors (N) über einen zweiten zusätzlichen Transistor (Q2) mit dem zweiten Pol (lSup) der Versorgungsspannung verbunden ist.

8. Anordnung nach Anspruch 7,
**dadurch gekennzeichnet,**
**daß** die Gateanschlüsse der zusätzlichen Transistoren (Q1, Q2) so angesteuert werden, daß sich jeweils einer der zusätzlichen Transistoren im leitenden Zustand, und der jeweils andere der zusätzlichen Transistoren im nicht leitenden Zustand befindet.

9. Anordnung nach Anspruch 7 oder 8,
**dadurch gekennzeichnet,**
**daß** die Gateanschlüsse der zusätzlichen Transistoren (Q1, Q2) durch das der Anordnung zugeführte Eingangssignal (DIGIN) oder ein darauf basierendes Signal angesteuert werden.

10. Anordnung nach einem der Ansprüche 7 bis 9,
**dadurch gekennzeichnet,**
**daß** der Gateanschluß des ersten umzuschaltenden Transistors (P) über einen dritten zusätzlichen Transistor (Q3) mit dem ersten Pol (hSup) der Versorgungsspannung verbunden ist, wobei dieser dritte zusätzliche Transistor in Abhängigkeit von der sich zwischen den umzuschaltenden Transistoren (P, N) einstellenden Spannung (DIGOUT) und dem der Anordnung zugeführten Eingangssignal (DIGIN) angesteuert wird.

11. Anordnung nach einem der Ansprüche 7 bis 10,
**dadurch gekennzeichnet,**
**daß** der Gateanschluß des ersten umzuschaltenden Transistors (P) über einen vierten zusätzlichen Transistor (Q4) mit dem ersten Pol (hSup) der Versorgungsspannung verbunden ist, wobei dieser vierte zusätzliche Transistor in Abhängigkeit von der am Gateanschluß des zweiten umzuschaltenden Transistors (N) anliegenden Spannung und dem der Anordnung zugeführten Eingangssignal (DIGIN) angesteuert wird.

12. Anordnung nach einem der Ansprüche 7 bis 11,
**dadurch gekennzeichnet,**
**daß** der Gateanschluß des zweiten umzuschaltenden Transistors (N) über einen fünften zusätzlichen Transistor (Q5) mit dem zweiten Pol (lSup) der Versorgungsspannung verbunden ist, wobei dieser fünfte zusätzliche Transistor in Abhängigkeit von der sich zwischen den umzuschaltenden Transistoren (P, N) einstellenden Spannung (DIGOUT) und dem der Anordnung zugeführten Eingangssignal (DIGIN) angesteuert wird.

13. Anordnung nach einem der Ansprüche 7 bis 12,
**dadurch gekennzeichnet,**
**daß** der Gateanschluß des zweiten umzuschaltenden Transistors (N) über einen sechsten zusätzlichen Transistor (Q6) mit dem zweiten Pol (lSup) der Versorgungsspannung verbunden ist, wobei dieser sechste zusätzliche Transistor in Abhängigkeit von der am Gateanschluß des ersten umzuschaltenden Transistors (P) anliegenden Spannung und dem der Anordnung zugeführten Eingangssignal (DIGIN) angesteuert wird.

14. Anordnung nach einem der vorhergehenden Ansprüche,
**dadurch gekennzeichnet,**
**daß** der Gateanschluß des ersten umzuschaltenden Transistors (P) und der Gateanschluß des zweiten umzuschaltenden Transistors (N) über ein oder mehrere als Widerstände wirkende Elemente (T1, T2) verbunden sind.

15. Anordnung nach Anspruch 14,
**dadurch gekennzeichnet,**
**daß** die als Widerstände wirkenden Elemente (T1, T2) durch Transistoren gebildet werden.

16. Anordnung nach Anspruch 15,
**dadurch gekennzeichnet,**
**daß** auf die Ansteuerung der Transistoren (T1, T2) über einen der Anordnung zugeführten Biasstrom (IBias) Einfluß genommen werden kann.

17. Verfahren zum gleichzeitigen Umschalten eines sich im leitenden Zustand befindenden Transistors in den nicht leitenden Zustand und eines dazu in Reihe geschalteten, sich im nicht leitenden Zustand befindenden Transistors in den leitenden Zustand,
**dadurch gekennzeichnet,**
**daß** dafür gesorgt wird, daß sich beim Umschalten der Transistoren (P, N) vom leitenden in den nicht leitenden Zustand bzw. vom nicht leitenden in den leitenden Zustand das Gatepotential des Transistors, der durch das Umschalten vom nicht leitenden Zustand in den leitenden Zustand gebracht wird, langsamer ändert als das Gatepotential des Transistors, der durch das Umschalten vom leitenden Zustand in den nicht leitenden Zustand gebracht wird.

18. Verfahren nach Anspruch 17,
**dadurch gekennzeichnet,**
**daß** dafür gesorgt wird, daß sich beim Umschalten der Transistoren (P, N) vom leitenden in den nicht leitenden Zustand bzw. vom nicht leitenden in den leitenden Zustand die Gatepotentiale der Transistoren gleichzeitig zu ändern beginnen.

19. Verfahren nach Anspruch 117 oder 18,
**dadurch gekennzeichnet,**
**daß** die Transistoren (P, N) während des Umschaltens vom leitenden in den nicht leitenden Zustand bzw. vom nicht leitenden in den leitenden Zustand so angesteuert werden, daß in Phasen, in welchen sich keiner der Transistoren im nicht leitenden Zustand befindet, wenigstens einer der Transistoren in einen Zustand versetzt wird, in welchem er als eine den Stromfluß durch die Transistoren begrenzende Stromquelle wirkt.

20. Verfahren nach einem der Ansprüche 17 bis 19,
**dadurch gekennzeichnet,**
**daß** einer der Transistoren (P, N) ein PMOS-Transistor ist, und der andere Transistor ein NMOS-Transistor ist.

21. Verfahren nach einem der Ansprüche 17 bis 20,
**dadurch gekennzeichnet,**
**daß** der Sourceanschluß des einen Transistors (P) mit einem ersten Pol (hSup) einer Versorgungsspannung verbunden ist, und daß der Sourceanschluß des anderen Transistors (N) mit einem zweiten Pol (lSup) der Versorgungsspannung verbunden ist.

22. Verfahren nach einem der Ansprüche 17 bis 21,
**dadurch gekennzeichnet,**
**daß** es von einem der Anordnung zugeführten Eingangssignal (DIGIN) abhängt, welcher der Transistoren (P, N) sich im leitenden Zustand befindet und welcher der Transistoren sich im nicht leitenden Zustand befindet, wobei die Transistoren jedoch nicht durch dieses Eingangssignal angesteuert werden.

23. Verfahren nach einem der Ansprüche 17 bis 22,
**dadurch gekennzeichnet,**
**daß** der Gateanschluß des ersten Transistors (P) über einen ersten zusätzlichen Transistor (Q1) mit dem ersten Pol der (hSup) Versorgungsspannung verbunden ist, und daß der Gateanschluß des zweiten Transistors (N) über einen zweiten zusätzlichen Transistor (Q2) mit dem zweiten Pol (lSup) der Versorgungsspannung verbunden ist.

24. Verfahren nach Anspruch 23,
**dadurch gekennzeichnet,**
**daß** die Gateanschlüsse der zusätzlichen Transistoren (Q1, Q2) so angesteuert werden, daß sich jeweils einer der zusätzlichen Transistoren im leitenden Zustand, und der jeweils andere der zusätzlichen Transistoren im nicht leitenden Zustand befindet.

25. Verfahren nach Anspruch 23 oder 24,
**dadurch gekennzeichnet,**
**daß** die Gateanschlüsse der zusätzlichen Transistoren (Q1, Q2) durch das der Anordnung zugeführte Eingangssignal (DIGIN) oder ein darauf basierendes Signal angesteuert werden.

26. Verfahren nach einem der Ansprüche 23 bis 25,
**dadurch gekennzeichnet,**
**daß** der Gateanschluß des ersten umzuschaltenden Transistors (P) über einen dritten zusätzlichen Transistor (Q3) mit dem ersten Pol (hSup) der Versorgungsspannung verbunden ist, wobei dieser dritte zusätzliche Transistor in Abhängigkeit von der sich zwischen den umzuschaltenden Transistoren (P, N) einstellenden Spannung (DIGOUT) und dem der Anordnung zugeführten Eingangssignal (DIGIN) angesteuert wird.

27. Verfahren nach einem der Ansprüche 23 bis 26,
**dadurch gekennzeichnet,**
**daß** der Gateanschluß des ersten umzuschaltenden Transistors (P) über einen vierten zusätzlichen Transistor (Q4) mit dem ersten Pol (hSup) der Versorgungsspannung verbunden ist, wobei dieser vierte zusätzliche Transistor in Abhängigkeit von der am Gateanschluß des zweiten umzuschaltenden Transistors (N) anliegenden Spannung und dem der Anordnung zugeführten Eingangssignal (DIGIN) angesteuert wird.

28. Verfahren nach einem der Ansprüche 23 bis 27,
**dadurch gekennzeichnet,**
**daß** der Gateanschluß des zweiten umzuschaltenden Transistors (N) über einen fünften zusätzlichen Transistor (Q5) mit dem zweiten Pol (lSup) der Versorgungsspannung verbunden ist, wobei dieser fünfte zusätzliche Transistor in Abhängigkeit von der sich zwischen den umzuschaltenden Transistoren (P, N) einstellenden Spannung (DIGOUT) und dem der Anordnung zugeführten Eingangssignal (DIGIN) angesteuert wird.

29. Verfahren nach einem der Ansprüche 23 bis 28,
**dadurch gekennzeichnet,**
**daß** der Gateanschluß des zweiten umzuschaltenden Transistors (N) über einen sechsten zusätzlichen Transistor (Q6) mit dem zweiten Pol (lSup) der Versorgungsspannung verbunden ist, wobei dieser sechste zusätzliche Transistor in Abhängigkeit von der am Gateanschluß des ersten umzuschaltenden Transistors (P) anliegenden Spannung und dem der Anordnung zugeführten Eingangssignal (DIGIN) angesteuert wird.

30. Verfahren nach einem der Ansprüche 17 bis 29,
**dadurch gekennzeichnet,**
**daß** der Gateanschluß des ersten umzuschaltenden Transistors (P) und der Gateanschluß des zweiten umzuschaltenden Transistors (N) über ein oder mehrere als Widerstände wirkende Elemente (T1, T2) verbunden sind.

31. Verfahren nach Anspruch 30,
**dadurch gekennzeichnet,**
**daß** die als Widerstände wirkenden Elemente (T1, T2) durch Transistoren gebildet werden.

32. Verfahren nach Anspruch 31,
**dadurch gekennzeichnet,**
**daß** auf die Ansteuerung der Transistoren (T1, T2) über einen der Anordnung zugeführten Biasstrom (IBias) Einfluß genommen werden kann.
